Europäisches Patentamt

European Patent Office

Office européen des brevets

(11) Publication number: **0 198 501 B1**

## EUROPEAN PATENT SPECIFICATION

(45) Date of publication of patent specification: **01.07.92**

(21) Application number: **86105342.9**

(22) Date of filing: **17.04.86**

(51) Int. Cl.5: **H01L 21/00, B25J 15/02, B25J 9/10, B25J 9/14, H05K 13/02, H05K 13/00**

(54) Gripping Device.

(30) Priority: **17.04.85 JP 80110/85**
**17.04.85 JP 80111/85**
**19.04.85 JP 82309/85**

(43) Date of publication of application:
**22.10.86 Bulletin 86/43**

(45) Publication of the grant of the patent:
**01.07.92 Bulletin 92/27**

(84) Designated Contracting States:
**DE FR GB**

(56) References cited:
**DE-A- 2 345 856**
**FR-A- 553 283**
**GB-A- 862 174**
**US-A- 3 403 238**

**PATENT ABSTRACTS OF JAPAN vol. 7, no. 276 (E-215) 1421 09 December 1983, & JP-A-58 155736**

**"Report of Investigation and Researches on Developments of Applications of Shape Memory Alloys", Osaka Science and Tech-**

**nology Center in Japan, March 1983, pp 110-111**

(73) Proprietor: **HITACHI, LTD.**
**6, Kanda Surugadai 4-chome**
**Chiyoda-ku, Tokyo 100(JP)**

(72) Inventor: **Hosoda, Yuji**
**3602, Shimoinayoshi Chiyoda-mura**
**Niihari-gun Ibaraki-ken(JP)**
Inventor: **Honma, Kazuo**
**3769-2, Ami Gakkoukukita Ami-machi**
**Inashiki-gun Ibaraki-ken(JP)**
Inventor: **Fujie, Masakatsu**
**531-328, Taguu Ushiku-machi**
**Inashiki-gun Ibaraki-ken(JP)**

(74) Representative: **Patentanwälte Beetz sen. - Beetz jun. Timpe - Siegfried - Schmitt-Fumian**
**Steinsdorfstrasse 10**
**W-8000 München 22(DE)**

## Description

### BACKGROUND OF THE INVENTION:

The present invention relates to a gripping device, and more particularly to a gripping device which is well suited to grasp and convey a sheet-like object to-be-grasped such as a semiconductor wafer.

As regards the handling of sheet-like objects to-be-grasped such as semiconductor wafers, various measures including a system for handling the object by the use of vacuum suction and a system for grasping the outer peripheral edge of the object have heretofore been proposed for the purpose of preventing harmful matters such as dust from adhering to the wafer (official gazettes of Japanese Patent Application Laid-open No. 58-75844 and Japanese Patent Application Laid-open No. 58-155736).

Since the gripping devices of this type comprise slide portions, for example, a pin coupling and a slide surface which form dust sources, it is the actual situation that they cannot maintain high degrees of cleanness on the surfaces of the semiconductor wafers.

Meanwhile, as a gripping device for grasping an object in the ordinary atmosphere, a device which opens and closes grip members owing to the combination between a bias spring and a shape memory alloy member in the form of a coiled spring is described in 'Report of Investigation and Researches on Developments of Applications of Shape Memory Alloys', pp. 110 - 111, published by (Incorporated Foundation) Osaka Science and Technology Center in Japan, Committee of Investigation and Researches on Developments of Applications of Shape Memory Alloys in March 1983. With this gripping device, the structure around the shape memory alloy member formed into the coiled spring becomes complicated, and the use in a clean environment is not taken into consideration. Moreover, since the shape memory alloy is in the form of the coiled spring, the cooling efficiency thereof is inferior, and the grip-member opening and closing operation of the gripping device is slow, so that the device has been unsuited to handling in a system of which high speed operations are required.

### SUMMARY OF THE INVENTION:

An object of the present invention is to provide a gripping device which produces little dust and the grip members of which open and close with good responsiveness.

Said object is achieved, according to the present invention, by a gripping device as claimed in claim 1.

Further advantageous features are claimed in the dependent claims.

Namely, instead of a driver in coiled spring form of the prior art a driver made of a string or plate form shape memory alloy is disposed across said grip members.

Owing to such a construction, any slide portions can be dispensed with, so that the gripping device producing little dust can be provided. Moreover, since the shape memory alloy serving as the driver of the grip members is made as string or plate form, the heating and cooling speeds thereof become high, so that the responsiveness of the operations of opening and closing the grip members can be enhanced.

Other objects, advantages and features of the present invention will become apparent from embodiments to be described below.

### BRIEF DESCRIPTION OF THE DRAWINGS:

Figs. 1 - 4 are front views each showing an embodiment of a gripping device according to the present invention;
Figs. 5 - 12 are perspective views each showing another example of a shape memory alloy member for use in the device of the present invention;
Figs. 13 - 18 are front views each showing an embodiment of the gripping device of the present invention;
Fig. 19 is a front view, partly in section, showing another embodiment of the device of the present invention;
Fig. 20 is a sectional view showing another example of a fixing portion which constitutes the device of the present invention shown in Fig. 19;
Figs. 21 and 22 are sectional views each showing another example of a pneumatic portion which constitutes the device of the present invention shown in Fig. 19;
Fig. 23 is a front view, partly in section, showing another embodiment of the device of the present invention shown in Fig. 19;
Fig. 24 is a sectional view showing the coupling construction of a pneumatic portion and a fixing portion in the embodiment shown in Fig. 23; and
Fig. 25 is a front view showing still another embodiment of the device of the present invention shown in Fig. 19.

### DETAILED DESCRIPTION OF THE PREFERRED EMBODIMENTS:

Now, embodiments of the present invention will be described with reference to the drawings.

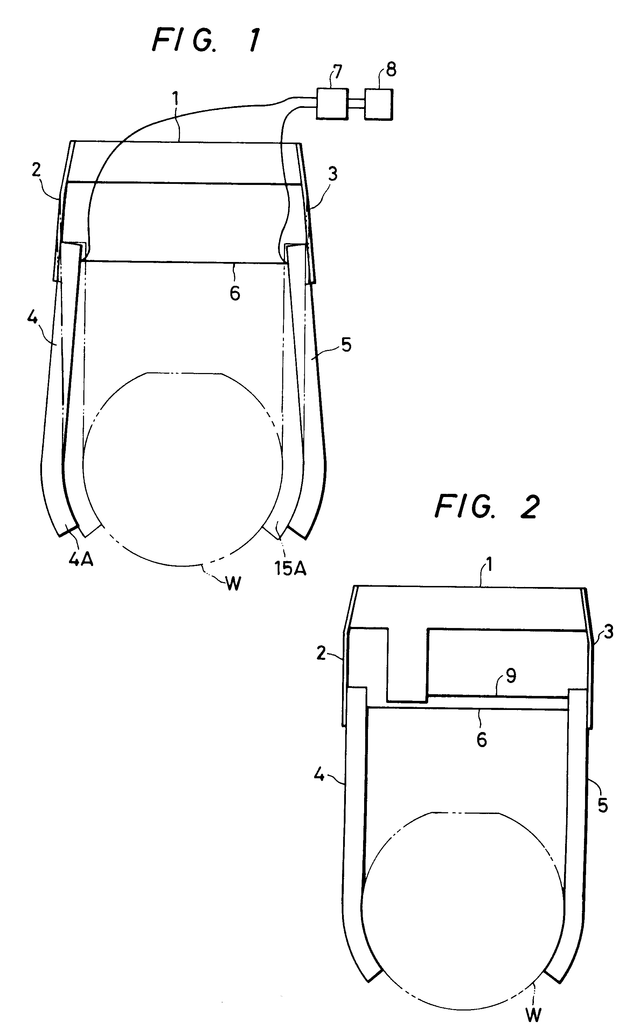

Fig. 1 shows an embodiment of a gripping device according to the present invention. In this figure, letter W indicates a sheet-like object to-be-grasped such as semiconductor wafer. A base part 1, which constitutes the gripping device of the present invention, is installed on the end of the arm of a robot by way of example. Either end of the base part 1 has one end of a corresponding elastic member 2 or 3 mounted thereon. Grip members 4 and 5 are respectively attached to the other ends of the elastic members 2 and 3. The distal ends of the respective grip members 4 and 5 are formed with holding portions 4A and 5A which hold the lower peripheral edge of the object to-be-grasped W. A string form member of shape memory alloy 6 which serves as a driver for opening and closing the grip members 4 and 5 is disposed across these grip members 4 and 5. The shape memory alloy 6 memorizes its shape so that, when heated, it may generate forces of recovery reducing its length. This shape memory alloy 6 is connected to a power source 8 through a switch 7. The aforementioned elastic members 2 and 3 are endowed with initial flexures for urging the grip members 4 and 5 in the opening direction.

Next, the operation of the above embodiment of the gripping device of the present invention will be described.

In the first place, there will be explained the operation of gripping the object to-be-grasped W in the ungrasped state of the object W indicated by solid lines in Fig. 1. When heated, the shape memory alloy 6 generates the recovery forces against the forces of deformation of the elastic members 2 and 3 and draws the grip members 4 and 5 to each other. As a result, the grip members 4 and 5 nip the object to-be-grasped W in such a form that, as indicated by dot-and-dash lines in Fig. 1, the holders 4A and 5A hold the lower peripheral edge of the object W without applying great pressing forces to the object W.

Subsequently, in a case where the object to-be-grasped W having been shifted to a desired position is to be placed on a jig or the like, the shape memory alloy 6 is cooled contrariwise to the above operation. Then, the shape memory alloy 6 has its recovery forces lowered, so that the grip members 4 and 5 are opened by the deformation forces of the elastic members 2 and 3, to release the object W. Thus, the object to-be-grasped W can be placed on the jig or the like.

Owing to such a construction, dust is little produced from the grip device in the operation of gripping the object to-be-grasped W, so that the object is free from the adhesion of dust and can be handled cleanly. In addition, since the shape memory alloy 6 for opening and closing the grip members 4 and 5 is of string form, the heating and cooling speeds thereof are high, and the responsiveness of the operations of opening and closing the grip members 4 and 5 is favorable. -

Fig. 2 shows another embodiment of the gripping device of the present invention. In this figure, the same symbols as in Fig. 1 indicate identical portions. This embodiment consists in that another shape memory alloy member 9 is disposed across the base 1 and one 5 of the grip members.

Owing to such a construction, in a case where the spring characteristics of the elastic members 2 and 3 differ in points of manufacture, the deviation of the grip position of the object to-be-grasped W gripped by the grip members 2 and 3, that is, the deviation thereof within the sheet of Fig. 2 can be corrected by the heating and cooling of the shape memory alloy 9. Besides, in a case where the spring characteristics are substantially the same, the object to-be-grasped W gripped by the grip members 4 and 5 can be moved rightwards or leftwards on the sheet of Fig. 2 by the heating and cooling of the shape memory alloy 9.

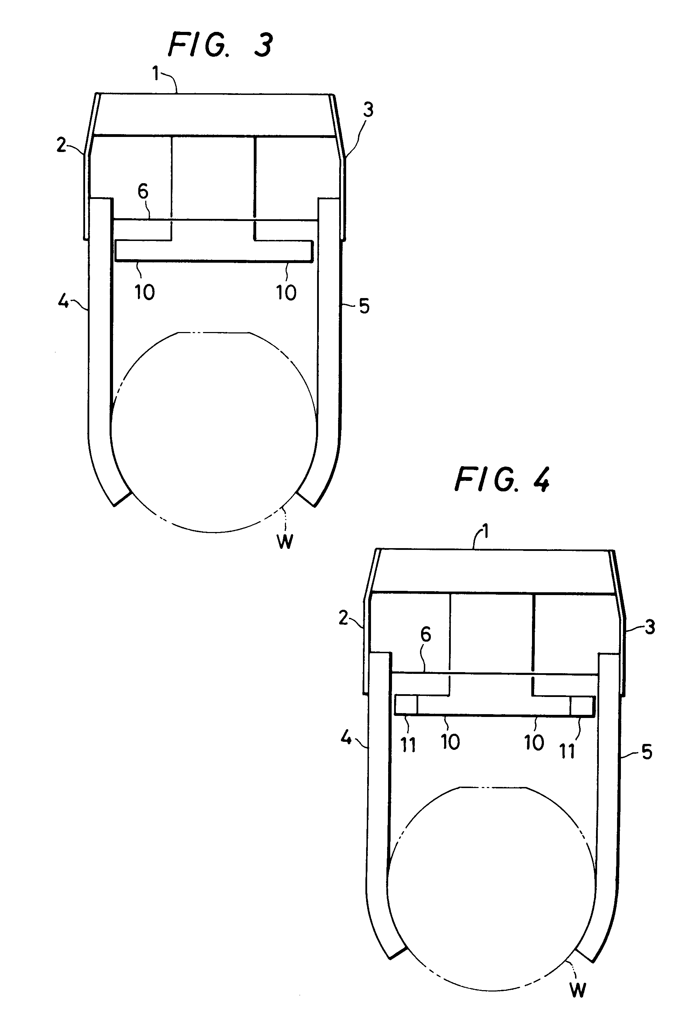

Fig. 3 shows still another embodiment of the gripping device of the present invention. In this figure, the same symbols as in Fig. 1 denote identical portions. This embodiment consists in that the base part 1 is provided with stoppers 10 for restraining the magnitudes of the closing operations of the grip members 4 and 5.

Owing to such a construction, when the object to-be-grasped W is to be gripped by the grip members 4 and 5, the interval between the grip members 4 and 5 can be determined constant without depending upon the recovery forces of the shape memory alloy 6. As a result, the grip members 4 and 5 can grasp the object to-be-grasped W with fixed clearances therefrom, and they do not apply useless grasping forces to the object W.

Fig. 4 shows another embodiment of the gripping device of the present invention, in which the same symbols as in Fig. 3 denote identical portions. This embodiment consists in that cushion members 11 are mounted on the end faces of the stoppers 10.

According to this embodiment, when the object to-be-grasped W is to be gripped by the grip members 4 and 5, these grip members 4 and 5 collide with the cushion members 11, and the production of dust at the time of the collision can be reduced. Further, the clearances between the object to-be-grasped W and the grip members 4 and 5 can be adjusted by changing the recovery forces of the shape memory alloy 6. It is also possible to nip the object W with certain specified forces.

In the foregoing embodiments, the initial flexures of the elastic members 2 and 3 are afforded in the opening direction of the grip members 4 and 5, while the grip members 4 and 5 are operated to close by the tractive recovery forces of the shape memory alloy 6. However, it is also possible to establish the reverse characteristics to the above, in which the initial flexures of the elastic members 2 and 3 are afforded in the closing direction of the grip members 4 and 5, while the grip members 4 and 5 are operated to open by the compressive recovery forces of the shape memory alloy 6.

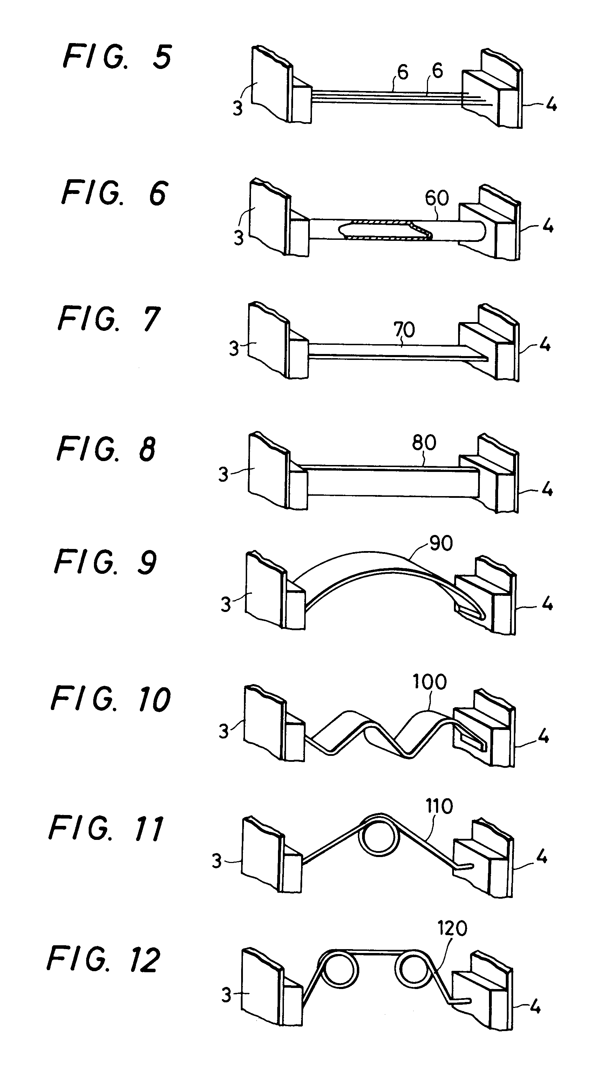

Each of the shape memory alloy members 6 and 9 stated before is not restricted to the single string form member. For example, a plurality of string form members 6 of the shape memory alloy may well be used as shown in Fig. 5, a pipe-shaped member 60 of the shape memory alloy as shown in Fig. 6 may well be used with the cooling taken into consideration, and a plate form member 70 or 80 of the shape memory alloy arranged horizontally or vertically may well be used as shown in Fig. 7 or Fig. 8. In addition, to the end of increasing the movement magnitudes of the grip members 4 and 5 and/or a third holder based on the shape memory alloy, it is possible to employ a curved plate form member 90 of the shape memory alloy as shown in Fig. 9, a corrugated member 100 of the shape memory alloy as shown in Fig. 10, and a string form member 110 or 120 of the shape memory alloy having one or two loop parts as shown in Fig. 11 or Fig. 12.

Further, as an expedient for heating the shape memory alloy, it is possible to adopt, not only resistance heating, but also induction heating, heating based on a hot fluid, radiant heating based on a laser beam, an infrared radiation beam or the like, and so forth.

Since the embodiments of the present invention thus far described produce little dust, they are well suited to handling wafers in semiconductor production processes.

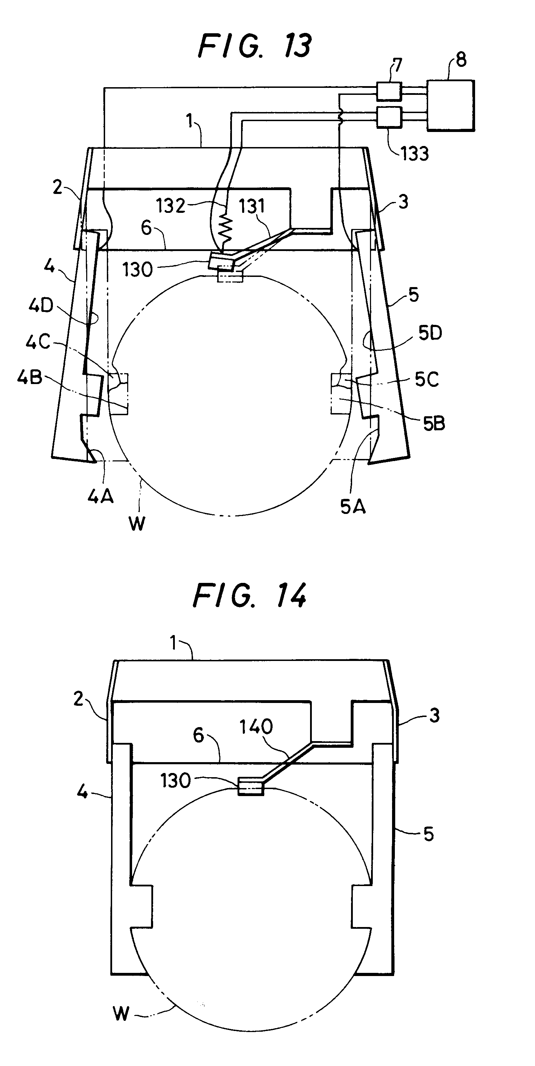

Fig. 13 shows still another embodiment of the gripping device of the present invention, in which letter W indicates a sheet-like object to-be-grasped such as semiconductor wafer. A base part 1 constituting the gripping device of the present invention is installed on, for example, the end of the arm of a robot. Either end of the base part 1 has one end of a corresponding elastic member 2 or 3 mounted thereon. Grip members 4 and 5 are respectively attached to the other ends of the elastic members 2 and 3. The distal ends of the grip members 4 and 5 are respectively provided with first holding portions 4A and 5A for holding the lower peripheral edge of the object to-be-grasped W, second holding portions 4B, 4C and 5B, 5C for holding the peripheral edge plane of the object to-be-grasped W, and portions 4D and 5D for permitting the upward movement of the object to-be-grasped W. A string form member 6 of a shape memory alloy 6 which serves as a driver for opening and closing the grip members 4 and 5 is disposed across the grip members 4 and 5. The shape memory alloy 6 memorizes its shape so that, when heated, it may generate forces of recovery reducing its length. This shape memory alloy 6 is connected to a power source 8 through a switch 7. The aforementioned elastic members 2 and 3 are endowed with initial flexures for urging the grip members 4 and 5 in the opening direction. A holder 130 which forms a third holding portion for holding the upper peripheral edge of the object to-be-grasped W is disposed between the grip members 4 and 5 and under the base part 1. This holder 130 is suspended from the base part 1 by an elastic member 131. Interposed between the holder 130 and the base part 1 is a string form member 132 of the shape memory alloy for pushing the object to-be-grasped W toward the distal ends of the grip members 4 and 5. The shape memory alloy 132 memorizes its shape so that, when heated, it may generate forces of recovery reducing its length. This shape memory alloy 132 is connected to the power source 8 through a switch 133. The elastic member 131 is endowed with an initial flexure in the direction of pressing the holder 130 against the object to-be-grasped W.

Next, the operation of the above embodiment of the gripping device of the present invention will be described.

First, there will be explained the operation of gripping the object to-be-grasped W in the ungrasped state of the object W indicated by solid lines in Fig. 13. At this time, the shape memory alloy 132 is held heated to generate the recovery forces against the force of deformation of the elastic member 131 and to draw the holder 130 toward the base part 1. When the shape memory alloy 6 is heated under this state, it generates the recovery forces against the forces of deformation of the elastic members 2 and 3 and draws both the grip members 4 and 5. As a result, the grip members 4 and 5 nip the object to-be-grasped W in such a form that, as indicated by dot-and-dash lines in Fig. 13, the first holders 4A and 5A hold the lower peripheral edge of the object W without applying great pressing forces to the object W. When the shape memory alloy 132 is subsequently cooled, the recovery forces thereof lower, so that the holder 130 is brought into touch with the upper peripheral edge of the object to-be-grasped W by the deformation force of the elastic member 131, to press the object W toward the distal ends of the grip members 4 and 5. Thus, the object to-be-grasped W is reliably nipped inside the grip members 4 and 5 and can therefore be conveyed to a desired position by the movement of the arm of the robot while holding any desired attitude such as the vertical or horizontal attitude.

Secondly, in a case where the object to-be-grasped W having been conveyed to the desired position is to be placed on a jig or the like, the shape memory alloy 132 is heated contrariwise to the above operation. Then, the shape memory alloy 132 generates the recovery forces against the deformation force of the elastic member 131 and draws the holder 130 toward the base part 1. Therefore, the force of pressing the object to-be-grasped W toward the distal ends of the grip members 4 and 5 is released, and the object W is allowed to move upwards along the movement permitting portions 4D and 5D of the grip members 4 and 5. Subsequently, the gripping device is caused to descend with the colliding speed between the object to-be-grasped W and the jig taken into consideration, until the object W falls on the jig. On this occasion, the object to-be-grasped W moves along the movement permitting portions 4D and 5D of the respective grip members 4 and 5 and can fall without undergoing any great collision. When the shape memory alloy 6 is thereafter cooled, the grip members 4 and 5 are opened by the deformation forces of the elastic members 2 and 3 to release the object to-be-grasped W. Thus, the object to-be-grasped W can be placed on the jig or the like.

Owing to such a construction, the object to-be-grasped W can be gripped without exerting any unreasonable force thereon, and yet, it can be conveyed in any desired attitude. Further, the object to-be-grasped W undergoes a slight impact at the fall on the jig and can be caused to fall stably.

Fig. 14 shows another embodiment of the gripping device of the present invention, in which the same symbols as in Fig. 13 indicate identical portions. In this embodiment, the holder 130 forming the third holding portion is suspended from the base part 1 through a member 140 of a shape memory alloy having the two-way shape memory effect, such as a nickel-titanium (Ni-Ti) alloy. The holder 130 is pressed against the object to-be-grasped W or is released therefrom by the change between a memory shape at temperatures higher than a certain point and a memory shape at lower temperatures memorized in the shape memory alloy 140.

Owing to such a construction, as in the preceding embodiment, the object to-be-grasped W can be gripped without any unreasonable force, and it can be caused to fall without any shock. Furthermore, according to this embodiment, the drive mechanism of the holder 130 can be simplified more than in the preceding embodiment shown in Fig. 13.

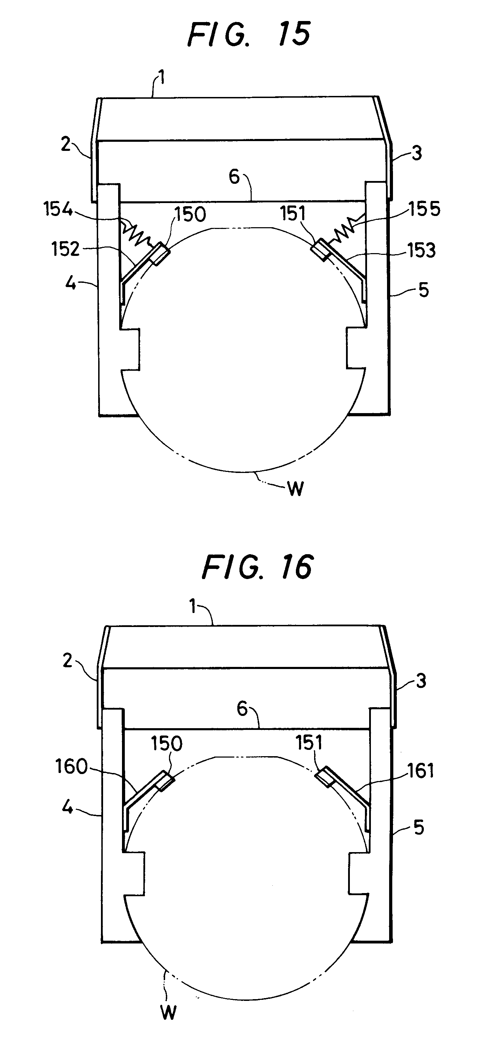

Fig. 15 shows still another embodiment of the gripping device of the present invention, in which parts of the same symbols as in Fig. 13 are identical portions. In this embodiment, the third holding portion is constructed of holders 150 and 151 which come into touch with two parts of the upper peripheral edge of the object to-be-grasped W, elastic members 152 and 153 which support the holders 150 and 151 on the grip members 4 and 5 respectively, and members 154 and 155 of a shape memory alloy which are respectively extended across the elastic members 152, 153 and the grip members 4, 5 in order to drive the holders 150, 151 against the elastic members 152, 153.

Owing to such a construction, the holders 150 and 151 can apply pressing forces to the object to-be-grasped W gripped by the grip members 4 and 5 or release them through the heating or cooling of the shape memory alloy members 154 and 155. Moreover, since the holders 150 and 151 exert the pressing forces toward the central part of the gripped object W, the positional deviation of the object W inside the grip members 4 and 5 can be suppressed. Further, likewise to the foregoing embodiments, this embodiment can grip the object to-be-grasped W without any unreasonable force and can cause the object W to fall without applying any shock.

Fig. 16 shows another embodiment of the gripping device of the present invention, in which parts of the same symbols as in Figs. 13 and 15 are identical portions. In this embodiment, the holders 150 and 151 constituting the third holding portion are supported by the respective grip members 4 and 5 through members 160 and 161 of a shape memory alloy having the two-way shape memory effect, such as a nickel-titanium (Ni-Ti) alloy. The holders 150 and 151 are pressed against the object to-be-grasped W or are released therefrom by the change between memory shapes at temperatures higher than a certain point and memory shapes at lower temperatures memorized in the shape memory alloy members 160 and 161.

Owing to such a construction, the same effects as in the foregoing embodiments can be attained, and the drive mechanisms of the holders 150 and 151 can be simplified more than in the embodiment shown in Fig. 15.

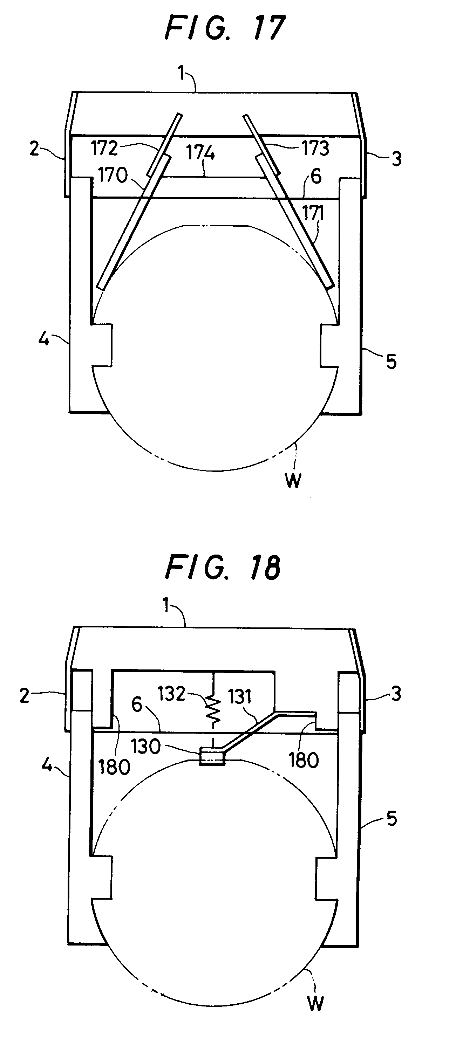

Fig. 17 shows still another embodiment of the gripping device of the present invention, in which parts of the same symbols as in Fig. 13 are identical portions. In this embodiment, the third holding portion is constructed of holders 170 and 171 which come into touch with two parts of the upper peripheral edge of the object to-be-grasped W, elastic members 172 and 173 which suspend the holders 170 and 171 from the base part 1 respectively, and a member 174 of a shape memory alloy which is extended across the holders 170 and 171.

Owing to such a construction, the holders 170 and 171 can apply pressing forces to the object to-be-grasped W gripped by the grip members 4 and 5 or release them through the heating or cooling of the shape memory alloy 174. Moreover, since the holders 170 and 171 exert the pressing forces toward the central part of the gripped object W, the positional deviation of the object W inside the grip members 4 and 5 can be suppressed. Further, the object to-be-grasped W can be gripped without any unreasonable force and can be caused to fall without undergoing any shock.

Fig. 18 shows another embodiment of the gripping device of the present invention, in which parts of the same symbols as in Fig. 13 are identical portions. This embodiment consists in that the base part 1 is provided with stoppers 180 which restrain the magnitudes of the closing operations of the grip members 4 and 5.

Owing to such a construction, when the object to-be-grasped W is to be gripped by the grip members 4 and 5, the interval between the grip members 4 and 5 can be determined constant without depending upon the recovery forces of the shape memory alloy 6. As a result, the grip members 4 and 5 can grasp the object to-be-grasped W with fixed clearances therefrom, and they do not apply useless grasping forces to the object W.

The stopper means shown in Fig. 18 is also applicable to the foregoing embodiments illustrated in Figs. 14 - 17.

In the embodiment shown in Fig. 13, the initial flexures of the elastic members 2 and 3 are afforded in the opening direction of the grip members 4 and 5, while the grip members 4 and 5 are operated to close by the tractive recovery forces of the shape memory alloy 6, and the initial flexure of the elastic member 131 is afforded in the closing direction of the holder 130, while the holder 130 is operated in the opening direction by the tractive recovery forces of the shape memory alloy 132. These aspects of setting the initial flexures of the elastic members 2, 3 and 131 and the shape memory of the shape memory alloy members 6 and 132 are also applicable to the embodiments illustrated in Figs. 15 and 17. It is also possible to set the reverse characteristics to the above, in which the initial flexures of the elastic members 2 and 3 are afforded in the closing direction of the grip members 4 and 5, while the grip members 4 and 5 are operated to open by the compressive recovery forces of the shape memory alloy 6, and in which the initial flexure of the elastic member 131 is afforded in the opening direction of the holder 130, while the holder 130 is closed by the compressive recovery forces of the shape memory alloy 132.

In the foregoing embodiments shown in Figs. 13 - 18, each of the shape memory alloy members 6, 132, 154, 155 and 174 is not restricted to the single string form member. For example, a plurality of string form members 6 of the shape memory alloy may well be used as shown in Fig. 5 referred to before, a pipe-formed member 60 of the shape memory alloy as shown in Fig. 6 may well be used with the cooling taken into consideration, and a plate form member 70 or 80 of the shape memory alloy arranged horizontally or vertically may well be used as shown in Fig. 7 or Fig. 8. In addition, to the end of increasing the movement magnitudes of the grip members 4 and 5 and/or the third holding portion based on the shape memory alloy, it is possible to employ a curved plate form member 90 of the shape memory alloy as shown in Fig. 9, a corrugated member 100 of the shape memory alloy as shown in Fig. 10, and a string form member 110 or 120 of the shape memory alloy having one or two loop parts as shown in Fig. 11 or Fig. 12.

Further, as an expedient for heating the shape memory alloy, it is possible to adopt, not only resistance heating, but also induction heating, heating based on a hot fluid, radiant heating based on a laser beam, an infrared radiation beam or the like, and so forth.

Since the embodiments of the present invention thus far described produce little dust, they are well suited to the handling of wafers in semiconductor production processes. According to the present invention, an object to-be-grasped can be gripped without exerting any unreasonable force and is not subjected to a great impact force when it falls down, so that the damages of the object to-be-grasped can be reduced. As a result, handling which can enhance the quality control of the objects to-be-grasped is possible.

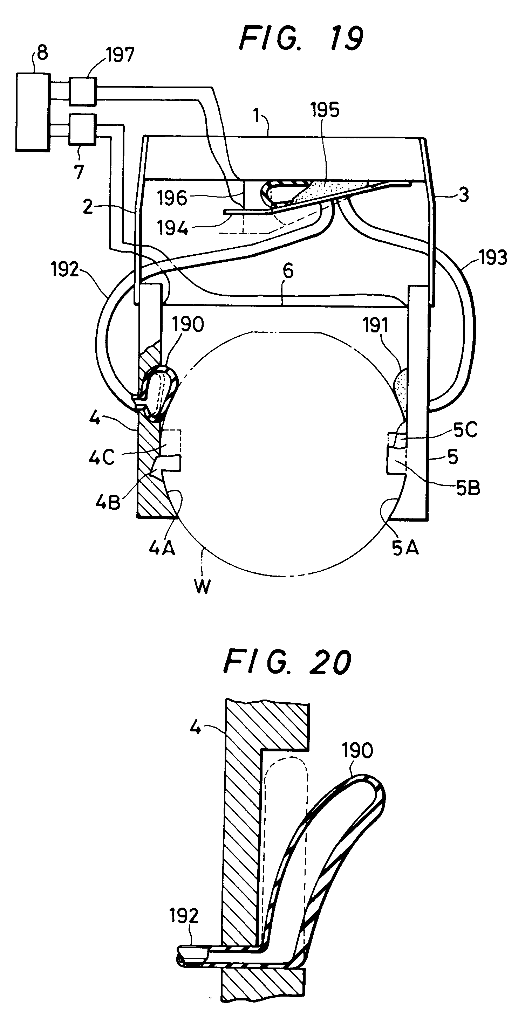

Fig. 19 shows another embodiment of the gripping device of the present invention. Referring to the figure, the gripping device of the present invention is so constructed that a base part 1 and grip members 4 and 5 are respectively connected by elastic members 2 and 3, and that the grip members 4 and 5 are connected by a linear member 6 of a shape memory alloy such as Ni-Ti alloy. In addition, fixing portions 190 and 191 for a semiconductor wafer W which are made of pouchy flexible members of high elasticity are provided centrally of the end faces of the grip members 4 and 5 confronting each other. The fixing portions 190 and 191 are connected through respective air tubes 192 and 193 to a pneumatic section (to be described below) mounted on the base part 1. The pneumatic section is constructed of an elastic member 194 which is attached to the base part 1, an air pressure applier 195 which is made of a pouchy flexible member and which is held between the elastic member 194 and the base part 1, and a linear member 196 of a shape memory alloy which couples the elastic member 194 and the base part 1. The elastic members 2 and 3 are previously endowed with initial flexures for urging the grip members 4 and 5 in an opening direction so as to exert forces of deformation on the shape memory alloy member 6. Likewise, the elastic member 194 is previously endowed with an initial flexure so as to exert a force of deformation on the shape memory alloy member 196. In addition, bents 4A and 5A which hold the lower peripheral edge of the semiconductor wafer W are formed in the parts of the distal ends of the respective grip members 4 and 5 confronting each other, and two rows of protrusions 4B, 4C and 5B, 5C juxtaposed in the aspect of sandwiching the plane of the semiconductor wafer W are respectively formed above the bents 4A, 5A of the grip members 4, 5. The shape memory alloy members 6 and 196 mentioned above are connected to a power source 8 through switches 7 and 197, respectively.

Next, the operation of the above embodiment of the present invention shown in Fig. 19 will be described.

When the shape memory alloy 6 is heated, it generates forces of recovery against the deformation forces of the elastic members 2 and 3, to draw the grip members 4 and 5 to each other and to cause them to nip the lower peripheral parts of the semiconductor wafer W. In contrast, when the shape memory alloy 6 is cooled, the grip members 4 and 5 are opened by the deformation forces of the elastic members 2 and 3, and the semiconductor wafer W is released. Besides, when the shape memory alloy member 196 is heated in case of gripping the object W to-be-grasped, it generates forces of recovery against the deformation force of the elastic member 194, and this elastic member 194 warps to compress the air pressure applier 195. Consequently, the fixing portions 190 and 191 have their internal pressures raised and are inflated, whereby the semiconductor wafer W is compressed and nipped between the fixing portions 190, 191 and the bents 4A, 5A of the grip members 4, 5. In contrast, when the shape memory alloy member 196 is cooled, the compression of the air pressure applier 195 is released by the deformation force of the elastic member 194 as indicated by broken lines in the figure. Consequently, the fixing portions 190 and 191 have their internal pressures lowered and are deflated, so that the semiconductor wafer W becomes free in the longitudinal direction of the grip members 4 and 5.

According to this embodiment, the semiconductor wafer W can be gripped and fixed without any unreasonable stress and can assume any desired attitude owing to the soft elastic forces of the fixing portions 190 and 191. In addition, in an operation wherein the grip device is caused to descend so as to place the semiconductor wafer W on a jig or the like, the fixing portions 190 and 191 are deflated to set the semiconductor wafer W free in the vertical direction, whereby the collision speed between the jig and the semiconductor wafer W can be controlled as the descent speed of the grip device, so the chipping of the semiconductor wafer attributed to the drop thereof can be prevented.

In the above embodiment, the forms of the shape memory alloy members 6 and 196 may be any of the string form, the arcuate form, the plate form, the pipe form etc. as shown in Figs. 5 - 12 referred to before. In addition, each of the elastic members 2, 3 and 194 may be in any of forms such as a leaf spring, a coiled spring and a torsion spring. Besides, the gripping device may well be so constructed that the initial flexures of the elastic members 2 and 3 are afforded in the closing direction of the grip members 4 and 5, whereupon these grip members 4 and 5 are opened by the compressive recovery forces of the shape memory alloy 6. Further, the gripping device may well be so constructed that the initial flexure of the elastic member 194 is afforded in the direction of compressing the air pressure applier 195, whereupon this air pressure applier 195 is released by the compressive recovery forces of the shape memory alloy 196. As regards heating the shape memory alloy 6 or 196, it is allowed to employ any method such as the resistance heating or induction heating of the material itself, heating with a hot fluid, or radiant heating with a laser beam, an infrared radiation beam or the like.

Fig. 20 shows another embodiment of the fixing portion which constitutes the device of the present invention shown in Fig. 19. In this embodiment, the pouchy flexible member forming the fixing portion 190 is thickened on a side facing the center of the gripping device.

Owing to such a construction, the fixing portions 190 and 191 bend toward the center of the gripping device as the internal pressures thereof rise.

According to this embodiment, the contact areas between the fixing portions 190, 191 and the upper peripheral parts of the semiconductor wafer W can be enlarged to relieve the concentration of stresses at the compression and to stably grip the semiconductor wafer W.

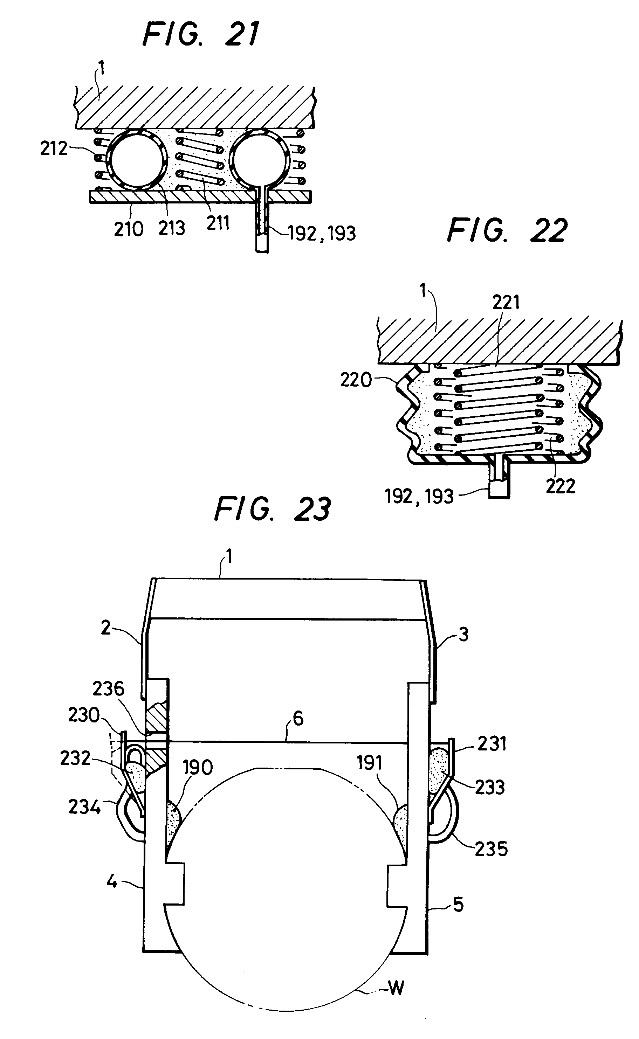

Fig. 21 shows another embodiment of the pneumatic section which constitute the device of the present invention. In this embodiment, the pneumatic section is so constructed that the base part 1 and a keeper plate 210 are coupled by a shape memory alloy member 211 and an elastic member 212 which are in the forms of coils, and that an air pressure applier 213 made of a doughnut-like flexible member is held between the base part 1 and the keeper plate 210. The interspace between the base part 1 and the keeper plate 210 changes according to the balance between the deformation force of the elastic member 212 and the recovery forces of the shape memory alloy 211 changing in dependence on temperatures, with the result that the air pressure in the air pressure applier 213 changes.

Fig. 22 shows still another embodiment of the pneumatic section which constitutes the device of the present invention. In this embodiment, the pneumatic section is so constructed that an air pressure applier 220 made of a bellows-like flexible member is fixed to the base part 1, and that the unfixed end face of the air pressure applier 220 and the base part 1 are coupled by a shape memory alloy member 221 and an elastic member 222 which are in the forms of coils. The interspace between the base part 1 and the end face of the air pressure applier 220 changes according to the balance between the deformation force of the elastic member 222 and the recovery forces of the shape memory alloy 221 changing in dependence on temperatures, with the result that the air pressure in the air pressure applier 220 changes.

In the above embodiments shown in Figs. 21 and 22, the shape memory alloy members 211, 221 and the elastic members 212, 222 may well be constructed in any other aspects than the coils, such as string forms, plate forms and pipe forms. The air pressure appliers 213, 220 may well be made of an elastic material so as to fulfill the function of the elastic members 212, 222.

Fig. 23 shows still another embodiment of the device of the present invention. In this embodiment, a pneumatic section is constructed of another elastic member 230 or 231 one end of which is fixed to the side of the corresponding grip member 4 or 5 remote from the gripping surface thereof and the other end of which has the corresponding end of the shape memory alloy member 6 coupled thereto, and an air pressure applier 232 or 233 which is made of a pouchy flexible member disposed between the elastic member 230 or 231 and the grip member 4 or 5, the air pressure appliers 232 and 233 being respectively coupled to the fixing portions 190 and 191 by air tubes 234 and 235. In addition, the shape memory alloy member 6 is connected to the elastic members 230 and 231 by passing through holes 236 provided in the respective grip members 4 and 5. In this construction, the elasticity of the other elastic members 230, 231 is set higher than that of the elastic members 2, 3. Then, after the grip of the grip members 4, 5 has been completed by the recovery forces of the shape memory alloy 6, the air pressure appliers 232, 233 are compressed to inflate the fixing portions 190, 191 and to fix the semiconductor wafer W.

According to this embodiment, the pneumatic sections can be driven by the shape memory alloy member 6 for driving the grip members, so that the structure is simplified. Moreover, the successive sequence operations of gripping and fixing the semiconductor wafer W can be realized by only the control of the shape memory alloy 6. In this embodiment, it is obvious that the pneumatic section may well be disposed on only one of the grip members.

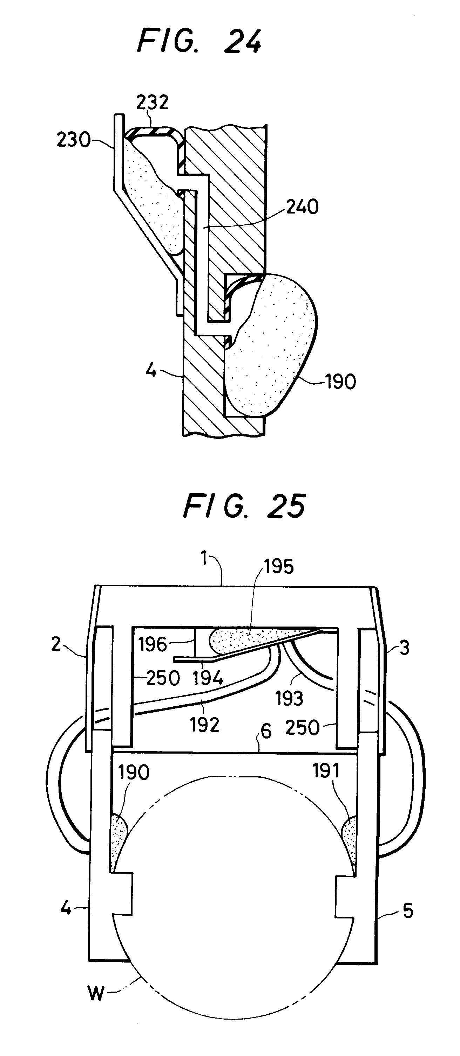

Fig. 24 shows still another embodiment of the gripping device of the present invention shown in Fig. 23. In this embodiment, air passages 240 are formed in the grip members 4, 5 in order to couple the air pressure appliers 232, 233 and the fixing portions 190, 191 in the embodiment illustrated in Fig. 23.

According to this embodiment, the air tubes need not be disposed outside, and it is possible to prevent the production of dust by the deformation breakdown of the air tube or the adherence of dust on the surface of the air tube.

Fig. 25 shows another embodiment of the gripping device of the present invention shown in Fig. 23. In this embodiment, the base part 1 is provided with protuberances 250 which touch the opposing end faces of the grip members 4 and 5 at the time of the grip.

According to this embodiment, the interval between the grip members 4 and 5 at the time of the grip can be determined constant irrespective of the recovery forces of the shape memory alloy 6, and the semiconductor wafer W can be nipped with fixed clearances.

As described above, according to the present invention, a gripping device is driven by a spring and a shape memory material including quite no mechanical slide portion, so that the production of dust attendant upon the operation can be reduced. In addition, owing to a construction in which the peripheral parts of a semiconductor wafer are nipped by grip members, the physical damages of the surfaces of the wafer can be lessened. It is accordingly possible to provide a gripping device which is readily thinned and which is well suited for introduction to a semiconductor manufacturing process.

**Claims**

1. A gripping device comprising a base part (1); grip members (4, 5) for gripping outer circumferential edges of two gripped members (W) connected to said base part (1); a driver (6) made of shape memory alloy connected between said grip members (4, 5) so as to open or close said grip members, resilient members (2, 3) arranged between said base part (1) and said grip members (4, 5) so as to bias each of said grip members (4, 5) in an opening direction or a closing direction and means (7, 8) for electrically energizing and heating said shape memory alloy,

**characterized** in that

said driver (6) is of linear or plate-like form and extends or retracts linearly in one direction.

2. A gripping device as defined in claim 1, wherein another driver (9) made of the shape memory alloy is extended across said base part (1) and one of said grip members (4, 5).

3. A gripping device as defined in claim 1, wherein said base part (1) is provided with protrusions (10) whose end faces confronting the corresponding grip members (4, 5) come into touch with said grip members (4, 5) when the object (W) is gripped.

4. A gripping device according to claim 1, wherein there is provided means for pushing the gripped members (W) against extreme ends of the grip members (4, 5).

5. A gripping device as defined in claim 4, wherein the pressing means comprises a holder (130) which comes into touch with at least one part of the outer peripheral edge of the object (W) to be grasped, and a driver (131, 132) which is extended across said holder (130) and said base part (1) so as to press said holder (130) against the object (W) to be grasped.

6. A gripping device as defined in claim 5, wherein said driver of said pressing means is constructed of an elastic member (131) which urges said holder (130) to move, and a member (132) of a shape memory alloy which operates against this elastic member (131).

7. A gripping device as defined in claim 5, wherein said driver of said pressing means is constructed of a member (140) of a shape memory alloy which moves said holder (130).

8. A gripping device as defined in claim 4, wherein the pressing means comprises a holder (150, 151) which comes into touch with at least one part of the outer peripheral edge of the object (W) to be grasped, and a driver (152, 154; 153, 155) which is extended across said holder (150, 151) and the corresponding grip member (4, 5) so as to press said holder against the object (W) to be grasped.

9. A gripping device as defined in claim 8, wherein said driver of said pressing means is constructed of an elastic member (152, 153) which urges said holder (150, 151) to move, and a member (154, 155) of a shape memory alloy which operates against this elastic member (152, 153).

10. A gripping device as defined in claim 8, wherein said driver of said pressing means is constructed of a member (160, 161) of a shape memory alloy which moves said holder (150, 151).

11. A gripping device according to claim 1 or 4, wherein a fixing part (190, 191) is provided comprising at least more than one bag-like resilient members arranged at end surfaces opposing between the grip members (4, 5), at least more than one pneumatic part (194, 195, 196) for applying a pneumatic pressure to said fixing part (190, 191) and an aeration pipe (192, 193) for connecting said pneumatic part and said fixing part.

12. A gripping device as defined in claim 1, wherein end faces of distal ends of said grip members (4, 5) confronting each other are formed so as to be bent toward said base part (1).

13. A gripping device as definedd in claim 12, wherein two rows of protrusions (4B, 4C, 5B, 5C) are formed longitudinally of end faces of said grip members (4, 5) confronting each other.

14. A gripping device as defined in claim 11, wherein said pneumatic part is so constructed that an air pressure applier (195) made of a pouchy flexible member is held between said base part (1) and an elastic member (194) one end of which is fixed to said base part (1) and the other end of which is connected to another member (196) of the shape memory alloy coupled to said base part (1).

15. A gripping device as defined in claim 11, wherein said pneumatic part is so constructed that an air pressure applier (213) made of a pouchy flexible member is held between said base part (1) and a keeper plate (210) which is coupled to said base part (1) by another shape memory alloy (211) and another elastic member (212) arranged in parallel.

16. A gripping device as defined in claim 11, wherein said pneumatic part is so constructed that an air pressure applier (220) made of a pouchy elastic member is held between said base part (1) and a keeper plate (210) which is coupled to said base by another shape memory alloy member (221).

17. A gripping device as defined in claim 11, wherein said pneumatic part is so constructed that one end of an air pressure applier (220) made of a bellows-like flexible member is connected to said base part (1), and that the other end of said air pressure applier (220) and said base part (1) are coupled by another shape memory alloy member (221) and another elastic member (222) arranged in parallel.

18. A gripping device as defined in claim 11, wherein said pneumatic section (230, 231) is so constructed that one end of an air pressure applier (232, 233) made of a bellows-like elastic member is connected to said base part (1), and that the other end of said air pressure applier (232, 233) and said base part (1) are coupled by another shape memory alloy member.

19. A gripping device as defined in claim 11, wherein said pneumatic section is so constructed that one end of another elastic member the other end of which is fixed to said grip member is coupled to one end of said shape memory alloy member, and that an air pressure applier which is made of a pouchy flexible member is connected between the coupling part and said grip member.

20. A gripping device as defined in claim 11, wherein said pneumatic section is so constructed that one end of an air pressure applier made of a pouchy elastic member is coupled to one end of said shape memory alloy member, and that the other end of said air pressure applier is connected to said grip member (4, 5).

21. A gripping device as defined in any of claims 14 to 20, wherein said fixing portion is so formed that a wall of its side to come into touch with said grip member (4, 5) is thinner than a wall of its side not to come into touch therewith.

22. A gripping device as defined in claim 19 or 20, wherein said air tube (240) is formed in said grip member (4, 5).

23. A gripping device as defined in any of claims 11 to 22, wherein said base part (1) is provided with protuberances which touch end faces of said grip members (4, 5) opposing to each other when the object (W) is gripped.

## Revendications

1. Dispositif de préhension comprenant une partie de base (1); des éléments de saisie (4,5) servant à saisir des bords circonférentiels extérieurs de deux éléments saisis (W) raccordés à ladite partie de base (1); un dispositif d'entraînement (6) formé par un alliage à mémoire de forme et raccordé entre lesdits éléments de saisie (4,5) de manière à ouvrir ou fermer ces derniers, des éléments élastiques (2,3) disposés entre ladite partie de base (1) et lesdits éléments de saisie (4,5) de manière à solliciter chacun desdits éléments de saisie (4,5) dans une direction d'ouverture ou une direction de fermeture et des moyens (7,8) pour exciter et chauffer électriquement ledit alliage à mémoire de forme,
caractérisé en ce que ledit dispositif d'entraînement (6) possède une forme linéaire ou une forme de plaque et se déploie ou se rétracte linéairement dans une direction.

2. Dispositif de préhension selon la revendication 1, dans lequel un autre dispositif d'entraînement (9) formé avec l'alliage à mémoire de forme s'étend entre ladite partie de base (1) et l'un desdits éléments de saisie (4,5).

3. Dispositif de préhension selon la revendication 1, dans lequel ladite partie de base (1) comporte des parties saillantes (10), dont les faces d'extrémité, qui sont situées en vis-à-vis des éléments de saisie correspondants (4,5), viennent en contact avec lesdits éléments de saisie (4,5), lors de la saisie de l'objet (W).

4. Dispositif de préhension selon la revendication 1, dans lequel il est prévu des moyens pour repousser les éléments saisis (W) contre les pointes d'extrémité des éléments de saisie (4,5).

5. Dispositif de préhension selon la revendication 1, dans lequel les moyens d'appui comprennent un dispositif de retenue (130) qui vient en contact avec au moins une partie du bord périphérique extérieur de l'objet (W) devant être saisi, et un dispositif d'entraînement (131,132), qui s'étend entre ledit dispositif de retenue (130) et ladite partie de base (1) de manière à repousser ledit élément de retenue (130) contre l'objet (W) devant être saisi.

6. Dispositif de préhension selon la revendication 5, dans lequel ledit dispositif d'entraînement desdits moyens d'appui est constitué par un élément élastique (131) qui repousse ledit élément de retenue (130) de manière à le déplacer, et un élément (132) formé d'un alliage à mémoire de forme, qui agit sur cet élément élastique (131).

7. Dispositif de préhension selon la revendication 5, dans lequel ledit dispositif d'entraînement desdits moyens d'appui est constitué par un élément (140) formé d'un alliage à mémoire de forme, qui déplace ledit élément de retenue (130).

8. Dispositif de préhension selon la revendication 4, dans lequel les moyens d'appui comprennent un dispositif de retenue (150,151), qui vient en contact avec au moins une partie du bord périphérique extérieur de l'objet (W) devant être saisi, et un dispositif d'entraînement (152,154; 153,155), qui s'étend entre ledit dispositif de retenue (150,151) et l'élément correspondant de saisie (4,5) de manière à repousser ledit dispositif d'appui contre l'objet (W) devant être saisi.

9. Dispositif de préhension selon la revendication 8, dans lequel ledit dispositif d'entraînement desdits moyens d'appui est constitué par un élément élastique (152,153), qui repousse ledit dispositif de support (150,151) de manière à le déplacer, et un élément (154,155) formé d'un alliage à mémoire de forme et qui agit sur cet élément élastique (152,153).

10. Dispositif de préhension selon la revendication 8, dans lequel ledit dispositif d'entraînement desdits moyens d'appui est constitué par un élément (160,161) formé d'un alliage à mémoire de forme et qui déplace ledit dispositif de retenue (150,151).

11. Dispositif de préhension selon la revendication 1 ou 4, dans lequel il est prévu une partie de fixation (190,191), qui est constituée au moins par plus d'un élément élastique en forme de sac, disposé sur des surfaces d'extrémité opposées entre les éléments de saisie (4,5), au moins plus d'une partie pneumatique (194,195,196) pour appliquer une pression pneumatique à ladite partie de fixation (190,191) et un tuyau d'aération (192,193) pour raccorder ladite partie pneumatique et ladite partie de fixation.

12. Dispositif de préhension selon la revendication 1, dans lequel des faces terminales des extrémités distales desdits éléments de saisie (4,5), situées en vis-à-vis, sont formées de manière à être recourbées en direction de ladite partie de base (1).

13. Dispositif de préhension selon la revendication 12, dans lequel deux rangées de parties saillantes (4B,4C,5B, 5C) sont formées dans la direction longitudinale des faces terminales desdits éléments de saisie (4,5), situées en vis-à-vis.

14. Dispositif de préhension selon la revendication 11, dans lequel ladite partie pneumatique est agencée de telle sorte qu'un dispositif (195) d'application de la pression d'air, qui est un élément flexible renflé, est maintenu entre ladite partie de base (1) et un élément élastique (194), dont une extrémité est fixée à ladite partie de base (1) et dont l'autre extrémité est raccordée à un élément (196) formé d'un alliage à mémoire de forme et couplé à ladite partie de base (1).

15. Dispositif de préhension selon la revendication 11, dans lequel ladite partie pneumatique est agencée de telle sorte qu'un dispositif (213) d'application de la pression d'air, formé d'un élément flexible renflé, est maintenu entre ladite partie de base (1) et une plaque de support (210), qui est couplée à ladite partie de base (1) par un autre élément (211) formé d'un alliage à mémoire de forme et par un autre élément élastique (212) disposé en parallèle.

16. Dispositif de préhension selon la revendication 11, dans lequel ladite partie pneumatique est agencée de telle sorte qu'un dispositif (213) d'application de la pression d'air, formé d'un élément flexible renflé, est maintenu entre ladite partie de base (1) et une plaque de support (210), qui est couplée à ladite partie de base par un autre élément (221) formé d'un alliage à mémoire de forme.

17. Dispositif de préhension selon la revendication 11, dans lequel ladite partie pneumatique est agencée de telle sorte qu'une extrémité dudit dispositif (220) d'application de la pression d'air, formé par un élément flexible en forme de soufflet,est raccordée à ladite partie de base (1), et que l'autre extrémité dudit dispositif (220) d'application de la pression d'air et ladite partie de base (1) sont couplées par un autre élément (221) formé d'un alliage à mémoire de forme et par un autre élément élastique (222) disposé en parallèle.

18. Dispositif de préhension selon la revendication 11, dans lequel ladite section pneumatique (230,232) est agencée de telle sorte qu'une extrémité d'un dispositif (232,233) d'application de la pression d'air, formé par un élément élastique en forme de soufflet, est raccordée à ladite partie de base (1), et que l'autre extrémité dudit dispositif (232,233) d'application de la pression d'air et ladite partie de base (1) sont couplées par un autre élément formé d'un alliage à mémoire de forme.

19. Dispositif de préhension selon la revendication 11, dans lequel ladite section pneumatique est agencée de telle sorte qu'une extrémité d'un autre élément élastique, dont l'autre extrémité est fixée audit élément de saisie, est couplée à une extrémité dudit élément formé d'un alliage à mémoire de forme, et qu'un dispositif d'application de la pression d'air, qui est formé par un élément flexible renflé, est monté entre la partie de couplage et ledit élément de saisie.

20. Dispositif de préhension selon la revendication 11, dans lequel ladite section pneumatique est agencée de telle sorte qu'une extrémité d'un dispositif d'application de la pression d'air formé d'un élément élastique renflé est accouplée à une extrémité dudit élément formé d'un alliage à mémoire de forme, et que l'autre extrémité du dispositif d'application de la pression d'air est raccordée audit élément de saisie (4,5).

21. Dispositif de préhension selon l'une quelconque des revendications 14 à 20, dans lequel ladite partie de fixation est formée de manière qu'une paroi de son côté, destiné à venir en contact avec ledit élément de saisie (4,5), est plus mince qu'une paroi de son côté non destiné à venir en contact avec cet élément.

22. Dispositif de préhension selon la revendication 19 ou 20, dans lequel ledit tube d'amenée d'air (240) est formé dans ledit élément de saisie (4,5).

23. Dispositif de préhension selon l'une quelconque des revendications 11 à 22, dans lequel ladite partie de base (1) comporte des protubérances qui viennent en contact avec des faces d'extrémité desdits éléments de saisie (4,5), situées en vis-à-vis l'une de l'autre lors de la saisie de l'objet (W).

## Patentansprüche

1. Greiferwerkzeug mit einem Basisteil (1), mit dem Basisteil verbundenen Greiforganen (4, 5) zum Erfassen von Außenumfangsrändern von zwei erfaßten Bauteilen (W), einem zwischen den Greiforganen (4, 5) derart angeschlossenen Antriebsorgan (6) aus einer Gestaltserinnerungslegierung, um die Greiforgane zu öffnen oder zu schließen, zwischen dem Basisteil (1) und den Greiforganen (4, 5) derart angebrachten Federorganen (2, 3), um jedes der Greiforgane (4, 5) in einer Öffnungsrichtung oder einer Schließrichtung vorzuspannen, und Mitteln (7, 8) zum elektrischen Speisen und Erhitzen der Gestaltserinnerungslegierung,

**dadurch gekennzeichnet**,

daß das Antriebsorgan (6) von linearer oder plattenartiger Form ist und sich linear in einer Richtung ausdehnt oder zusammenzieht.

2. Greiferwerkzeug nach Anspruch 1, wobei ein weiteres Antriebsorgan (9) über den Basisteil (1) und eines der Greiforgane (4, 5) ausgestreckt ist.

3. Greiferwerkzeug nach Anspruch 1, wobei der Basisteil (1) mit Vorsprüngen (10) versehen ist, deren den entsprechenden Greiforganen (4, 5) zugewandten Endflächen in Berührung mit den Greiforganen (4, 5) kommen, wenn der Gegenstand (W) erfaßt wird.

4. Greiferwerkzeug nach Anspruch 1, wobei eine Einrichtung zum Drücken der erfaßten Bauteile (W) gegen äußerste Enden der Greiforgane (4, 5) vorgesehen ist.

5. Greiferwerkzeug nach Anspruch 4, wobei die Drückeinrichtung einen Halter (130), der in Berührung mit wenigstens einem Teil des Außenumfangsrandes des zu erfassenden Gegenstands (W) kommt, und ein Antriebsorgan (131, 132) aufweist, das sich zwischen dem Halter (130) und dem Basisteil (1) so erstreckt, um den Halter (130) gegen den zu erfassenden Gegenstand (W) zu drücken.

6. Greiferwerkzeug nach Anspruch 5, wobei das Antriebsorgan der Drückeinrichtung aus einem elastischen Bauteil (131), das den Halter (130) in Bewegung treibt, und einem Bauteil (132) aus einer Gestaltserinnerungslegierung aufgebaut ist, das gegen dieses elastische Bauteil (131) wirkt.

7. Greiferwerkzeug nach Anspruch 5, wobei das Antriebsorgan der Drückeinrichtung aus einem Bauteil (140) aus einer Gestaltserinnerungslegierung besteht, das den Halter (130) bewegt.

8. Greiferwerkzeug nach Anspruch 4,
wobei die Drückeinrichtung einen Halter (150, 151), der in Berührung mit wenigstens einem Teil des Außenumfangsrandes des zu erfassenden Gegenstands (W) kommt, und ein Antriebsorgan (152, 154; 153, 155) aufweist, das sich zwischen dem Halter (150, 151) und dem entsprechenden Greiforgan (4, 5) so erstreckt, um den Halter gegen den zu erfassenden Gegenstand (W) zu drücken.

9. Greiferwerkzeug nach Anspruch 8,
wobei das Antriebsorgan der Drückeinrichtung aus einem elastischen Bauteil (152, 153), das den Halter (150, 151) in Bewegung treibt, und einem Bauteil (154, 155) aus einer Gestaltserinnerungslegierung aufgebaut ist, das gegen dieses elastische Bauteil (152, 153) wirkt.

10. Greiferwerkzeug nach Anspruch 8,
wobei das Antriebsorgan der Drückeinrichtung aus einem Bauteil (160, 161) aus einer Gestaltserinnerungslegierung besteht, das den Halter (150, 151) bewegt.

11. Greiferwerkzeug nach Anspruch 1 oder 4,
wobei ein Befestigungsteil (190, 191) vorgesehen ist, das wenigstens mehr als ein beutelartige federnde Organe, die an gegenüberliegenden Endflächen zwischen den Greiforganen (4, 5) angebracht sind, wenigstens mehr als ein pneumatisches Bauteil (194, 195, 196) zum Anlegen eines pneumatischen Drucks an das Befestigungsteil (190, 191) und ein Belüftungsrohr (192, 193) zum Verbinden des pneumatischen Bauteils und des Befestigungsteils aufweist.

12. Greiferwerkzeug nach Anspruch 1,
wobei Endflächen der einander zugewandten freien Enden der Greiforgane (4, 5) so ausgebildet sind, daß sie zum Basisteil (1) hin abgebogen sind.

13. Greiferwerkzeug nach Anspruch 12,
wobei zwei Reihen von Vorsprüngen (4B, 4C, 5B, 5C) längs der einander zugewandten Endflächen der Greiforgane (4, 5) gebildet sind.

14. Greiferwerkzeug nach Anspruch 11,
wobei das pneumatische Bauteil so aufgebaut ist, daß ein Luftdruckzuführer (195) aus einem sackartigen flexiblen Organ zwischen dem Basisteil (1) und einem elastischen Bauteil (194) gehalten wird, dessen eines Ende am Basisteil (1) befestigt ist und dessen anderes Ende mit einem weiteren Bauteil (196) aus der Gestaltserinnerungslegierung verbunden ist, das mit dem Basisteil (1) gekoppelt ist.

15. Greiferwerkzeug nach Anspruch 11,
wobei das pneumatische Bauteil so aufgebaut ist, daß ein Luftdruckzuführer (213) aus einem sackartigen flexiblen Organ zwischen dem Basisteil (1) und einer Halteplatte (210) gehalten wird, die mit dem Basisteil (1) durch eine weitere Gestaltserinnerungslegierung (211) und ein weiteres elastisches Bauteil (212), die parallel angeordnet sind, gekoppelt ist.

16. Greiferwerkzeug nach Anspruch 11,
wobei das pneumatische Bauteil so aufgebaut ist, daß ein Luftdruckzuführer (220) aus einem sackartigen elastischen Organ zwischen dem Basisteil (1) und einer Halteplatte (210) gehalten wird, die mit dem Basisteil durch eine weitere Gestaltserinnerungslegierung (221) gekoppelt ist.

17. Greiferwerkzeug nach Anspruch 11,
wobei das pneumatische Bauteil so aufgebaut ist, daß ein Ende eines Luftdruckzuführers (220) aus einem faltenbalgartigen flexiblen Organ mit dem Basisteil (1) verbunden ist und daß das andere Ende des Luftdruckzuführers (220) und das Basisteil (1) durch eine weitere Gestaltserinnerungslegierung (221) und ein weiteres elastisches Bauteil (222), die parallel angeordnet sind, gekoppelt sind.

18. Greiferwerkzeug nach Anspruch 11,
wobei der pneumatische Abschnitt (230, 231) so aufgebaut ist, daß ein Ende eines Luftdruckzuführers (232, 233) aus einem faltenbalgartigen elastischen Organ mit dem Basisteil (1) verbunden ist und daß das andere Ende des Luftdruckzuführers (232, 233) und das Basisteil (1) durch eine weitere Gestaltserinnerungslegierung gekoppelt sind.

19. Greiferwerkzeug nach Anspruch 11,
wobei der pneumatische Abschnitt so aufgebaut ist, daß ein Ende eines weiteren elastischen Bauteils, dessen anderes Ende am Greiforgan befestigt ist, mit einem Ende des Gestaltserinnerungslegierungsbauteils gekoppelt ist und daß ein Luftdruckzuführer, der aus einem sackartigen flexiblen Organ besteht, zwischen dem Kopplungsteil und dem Greiforgan angeschlossen ist.

20. Greiferwerkzeug nach Anspruch 11,
wobei der pneumatische Abschnitt so aufgebaut ist, daß ein Ende eines Luftdruckzuführers aus einem sackartigen elastischen Organ mit einem Ende des Gestaltserinnerungslegierungsbauteils verbunden ist und daß das andere Ende des Luftdruckzuführers mit dem Greiforgan (4, 5) verbunden ist.

21. Greiferwerkzeug nach irgendeinem der Ansprüche 14 bis 20,
wobei das Befestigungsteil so gebildet ist, daß eine Wand seiner in Berührung mit dem Greiforgan (4, 5) kommenden Seite dünner als eine Wand seiner nicht in Berührung damit kommenden Seite ist.

22. Greiferwerkzeug nach Anspruch 19 oder 20,
wobei das Luftrohr (240) im Greiforgan (4, 5) gebildet ist.

23. Greiferwerkzeug nach irgendeinem der Ansprüche 11 bis 22,
wobei das Basisteil (1) mit Vorsprüngen versehen ist, die einander gegenüberstehende Endflächen der Greiforgane (4, 5), wenn der Gegenstand (W) erfaßt wird, berühren.

# FIG. 1

# FIG. 2

*FIG. 3*

*FIG. 4*

16

FIG. 5

FIG. 6

FIG. 7

FIG. 8

FIG. 9

FIG. 10

FIG. 11

FIG. 12

## FIG. 13

## FIG. 14

EP 0 198 501 B1

*FIG. 15*

*FIG. 16*

19

## FIG. 17

1

2    172   174   173   3
170   6
171
4    5
W

## FIG. 18

1

2    3
132   131
6
130
180   180
4
5
W

# FIG. 19

# FIG. 20

## FIG. 21

## FIG. 22

## FIG. 23

## FIG. 24

## FIG. 25